# FASCICULE DE BREVET EUROPEEN

(11) **EP 3 242 079 B1**
(45) Date de publication et mention de la délivrance du brevet: **02.09.2020**
(21) Numéro de dépôt: 17169330.2
(22) Date de dépôt: 03.05.2017
(51) Int. Cl.: F21V 23/04, F21S 41/14, F21S 41/16, F21S 41/33, F21S 45/70, F21Y 115/30

(54) **MODULE LUMINEUX COMPORTANT UN ÉLÉMENT LASER**
LEUCHTMODUL, DAS EIN LASERELEMENT UMFASST
LIGHT MODULE COMPRISING A LASER ELEMENT

(30) Priorité: 04.05.2016 FR 1654056
(43) Date de publication de la demande: 08.11.2017
(73) Titulaire: Valeo Vision, 93012 Bobigny Cedex (FR)
(72) Inventeur: RENAUD, Pierre, 93012 BOBIGNY Cedex (FR)
(74) Mandataire: Oggioni, Baptiste

(56) Documents cités:
- EP-A2- 2 784 382
- DE-A1-102012 220 481
- DE-A1-102014 205 606

## Description

### DOMAINE TECHNIQUE DE L'INVENTION

L'invention concerne un module lumineux destiné à émettre un faisceau lumineux comportant un élément laser à semi-conducteur.

L'invention concerne plus particulièrement un module lumineux, notamment pour un véhicule automobile, destiné à émettre un faisceau lumineux sortant et comportant :
- au moins un élément laser à semi-conducteur configuré pour émettre un faisceau laser dans un premier cône de lumière ;
- un élément photoluminescent configuré pour convertir au moins une partie dudit faisceau laser ;
- un moyen optique pour transformer la lumière provenant de l'élément photoluminescent en ledit faisceau lumineux sortant orienté dans une direction d'émission, le moyens optique comportant une portion de guidage agencée pour guider au moins une partie de la lumière émise dans ledit premier cône de lumière dans un deuxième cône de lumière ;
- au moins un dispositif de détection d'une lumière incidente dépassant un seuil prédéterminé d'intensité lumineuse.

### ARRIERE PLAN TECHNIQUE DE L'INVENTION

Les éléments laser à semi-conducteur présentent des propriétés très avantageuses, par exemple une surface d'émission de lumière très réduite, un faisceau laser très intense et très collimaté. Les systèmes optiques pour lumière laser peuvent donc être conçus avec des distances focales beaucoup plus courtes que pour les systèmes utilisant des sources de lumière moins collimatées, par exemple les lampes à incandescence et les diodes électroluminescentes (LEDs). Les systèmes optiques pour lumière laser présentent ainsi un encombrement particulièrement réduit.

Les sources laser utilisées dans l'automobile comportent généralement un élément laser à semi-conducteur apte à émettre un faisceau laser globalement monochromatique de longueur d'onde donnée et un élément photoluminescent apte à convertir une partir du faisceau laser monochromatique en un faisceau de lumière présentant un spectre de longueur d'onde plus large que celui du faisceau laser.

Cependant, l'utilisation d'un élément laser à semi-conducteur pour de telles source lumineuse pour les modules lumineux de véhicules automobiles pose certains problèmes dus notamment au fait qu'une telle source lumineuse émet un faisceau de lumière cohérente sensiblement monochromatique lorsque l'élément photoluminescent est détérioré ou lorsqu'il est déplacé en dehors du trajet de la source laser. Ainsi, le type de laser utilisé pour des applications d'éclairage ou de signalisation embarqués sur un véhicule automobile émet un faisceau laser qui est susceptible de poser certains problèmes de sécurité en cas de défaillance de l'élément photoluminescent. Un tel faisceau laser est notamment nocif pour les yeux d'un observateur, ou risque tout au moins d'éblouir un usager de la route.

Par ailleurs, les fonctions d'éclairage ou de signalisation des véhicules automobiles requièrent des faisceaux lumineux présentant une lumière ayant un spectre plus étendu que celui d'un faisceau laser, par exemple une lumière blanche.

Pour résoudre les problèmes de sécurité tout en transformant le faisceau laser en un rayonnement lumineux adapté pour les fonctions d'éclairage ou de signalisation, il est connu d'interposer un élément photoluminescent sur le trajet du faisceau laser. Un tel élément photoluminescent comporte une substance photoluminescente qui est excitée par de la lumière dont la plage de longueur d'onde comprend celle du faisceau laser, par exemple du bleu. En conséquence, l'élément photoluminescent émet une lumière dont le spectre de longueurs d'onde s'étend dans une plage de longueurs d'onde excluant celle du faisceau laser ou décentrée par rapport à celle du faisceau laser, par exemple du jaune. Ainsi, au moins une partie de la lumière incidente d'une longueur d'onde donnée est convertie en lumière d'autres longueurs d'onde qui émise dans toutes les directions.

De plus, au moins une autre partie de la lumière incidente est dispersée par l'élément photoluminescent. De cette manière, la lumière dispersée et la lumière convertie se superposent additivement, par exemple pour former une lumière blanche.

Pour les raisons de sécurité évoquées précédemment, l'élément photoluminescent revêt ainsi une importance particulière. Si l'élément photoluminescent venait à être endommagé ou retiré du trajet du faisceau laser, par exemple suite à un choc, le faisceau laser non converti et concentré risque d'être émis par le module lumineux dans la direction initialement prévue pour le faisceau lumineux sortant. Dans ces cas, des mesures de sécurité doivent être envisagées pour éviter de mettre en danger les usagers de la route.

Une solution envisagée est de placer un dispositif de détection de la longueur d'onde du laser sur le trajet du faisceau laser en aval de l'élément photoluminescent. Ainsi, lorsque l'élément photoluminescent ne remplit plus son rôle, le faisceau laser touche directement le dispositif de détection. Si tel est le cas, l'alimentation de l'élément laser est interrompue par un moyen de pilotage de l'élément laser, par exemple une unité électronique de commande.

Cependant, de tels dispositifs sont généralement encombrants. EP 2 784 382 A2 et DE 10 2014 205 606 A1 décrivent des modules lumineux connus.

De plus, de tels dispositifs requièrent un agencement précis du dispositif de détection. Cela nécessite notamment une tolérance de positionnement très faible des moyens de guidage de la lumière par rapport au moyens optiques.

### BREF RESUME DE L'INVENTION

La présente invention propose un module lumineux du type décrit précédemment, caractérisé en ce que le dispositif de détection est agencé en dehors du deuxième cône de lumière et en ce que le module lumineux comporte un moyen de déviation agencé en travers du deuxième cône de lumière pour dévier la lumière incidente dans un troisième cône de lumière dirigé vers le dispositif de détection.

Le faisceau lumineux sortant est orienté vers l'extérieur du véhicule, par exemple vers l'avant, pour réaliser une fonction d'éclairage ou de signalisation.

Avantageusement, le troisième cône est orienté selon une direction distincte de la direction d'orientation du deuxième cône et/ou présente un angle d'ouverture supérieur à celui du deuxième cône.

Selon d'autres caractéristiques de l'invention :
- le moyen de déviation comporte au moins un élément optique qui est traversé par la lumière et qui comporte une face d'entrée de la lumière du deuxième cône de lumière et une face de sortie de la lumière selon le troisième cône de lumière ;
- l'élément optique dévie la lumière par réfraction ;
- l'élément optique est formé par un prisme ;
- l'élément optique est formé par une lentille ;
- le moyen de déviation comporte des moyens d'étalement de la lumière pour que le troisième cône de lumière présente un angle d'ouverture supérieur à celui du deuxième cône de lumière ;
- au moins l'une des faces parmi la face d'entrée et la face de sortie de l'élément optique est structurée pour étaler la lumière ;
- au moins l'une des faces parmi la face d'entrée et la face de sortie de l'élément optique présente un état de surface diffusant la lumière ; le moyen de déviation étant par exemple une plaque réalisée dans un matériau transparent ou translucide et dont au moins l'une des faces d'entrée ou de sortie, voire les deux, est grainée,
- l'élément optique est réalisé en un matériau diffusant la lumière ;
- le module lumineux comporte au moins deux dispositifs de détection qui sont chacun agencés dans le troisième cône de lumière ;
- chaque dispositif de détection est agencé en dehors du deuxième cône de lumière ;
- le moyen optique comporte une surface de réflexion dont une portion principale réfléchit de la lumière provenant de l'élément photoluminescent pour former ledit faisceau lumineux sortant ;
- la portion de guidage est formée par une portion secondaire de la surface de réflexion qui réfléchit la lumière issue du premier cône de lumière dans le deuxième cône de lumière ;
- la portion de guidage est formé par un orifice qui traverse une portion secondaire de la surface de réflexion ;
- le dispositif de détection comporte une photodiode ;
- le dispositif de détection et l'élément laser sont portés par un support commun, notamment par une carte électronique commune ;
- le module lumineux comporte un moyen de pilotage de l'élément laser qui est destiné à interrompre l'émission du faisceau laser lorsque le dispositif de détection détecte une intensité supérieure au seuil prédéterminé ;
- la portion de guidage du moyen optique guide au moins une partie de la lumière émise dans ledit premier cône de lumière dans un deuxième cône de lumière orienté vers une deuxième direction déterminée qui est différente de la première direction d'émission du faisceau lumineux sortant ;
- le moyen de déviation est formé d'au moins un élément optique séparé de l'élément portant la portion de guidage ;
- la portion de guidage est porté de manière fixe par le moyen optique.

### BREVE DESCRIPTION DES FIGURES

D'autres caractéristiques et avantages de l'invention apparaitront au cours de la lecture de la description détaillée qui va suivre pour la compréhension de laquelle on se reportera aux dessins annexés dans lesquels :
- la figure 1 est une vue schématique en coupe axiale qui représente un module lumineux avec un élément laser réalisé selon un premier mode de réalisation de l'invention, le module lumineux émettant un faisceau lumineux sortant ;
- la figure 2 est une vue similaire à celle de la figure 1 qui représente le module lumineux de la figure 1 en cas de dysfonctionnement, le faisceau laser étant guidé puis dévier vers un dispositif de détection ;
- la figure 3 est une vue similaire à celle de la figure 2 qui représente un deuxième mode de réalisation de l'invention dans lequel le moyen de déviation du faisceau lumineux comporte deux éléments optiques ;
- la figure 4 est une vue similaire à celle de la figure 3 qui représente un troisième mode de réalisation de l'invention dans lequel le moyen de déviation comporte un élément optique qui étale la lumière ;
- la figure 5 est une vue de détail qui représente l'élément optique de la figure 1 équipé de faces structurées pour étaler la lumière ;
- la figure 6 est une vue similaire à celle de la figure 5 qui représente une variante de réalisation de l'élément optique équipé de faces diffusant la lumière ;
- la figure 7 est une vue similaire à celle de la figure 4 qui représente un quatrième mode de réalisation de l'invention dans lequel le module lumineux comporte deux dispositifs de détection ;
- la figure 8 est une vue similaire à celle de la figure 7 qui représente une variante de réalisation de l'invention dans laquelle le moyen de déviation comporte un premier élément optique de déviation par réfraction et un deuxième élément optique d'étalement de la lumière ;
- la figure 9 est une vue similaire à celle de la figure 6 qui représente un moyen de déviation qui est équipé d'un élément optique apte à dévier la direction globale de propagation de la lumière par réfraction et à étaler la lumière ;
- la figure 10 est une vue similaire à celle des figures 1 à 4 qui représente une variante de réalisation de l'invention ;
- la figure 11 est une vue similaire à celle des figures 1 à 4 qui représente une autre variante de réalisation de l'invention.

### DESCRIPTION DETAILLEE DES FIGURES

Dans la suite de la description des éléments présentant une structure identique ou des fonctions analogues seront désignés par des mêmes références.

Dans la description et les revendications, le terme "cône de lumière" s'applique à l'enveloppe d'un faisceau lumineux. Un tel cône de lumière n'est pas limité aux seuls cônes de révolution. Ainsi on comprendra qu'un cône de lumière peut présenter des sections de formes variées, par exemple ronde, ovoïde, rectangulaire...

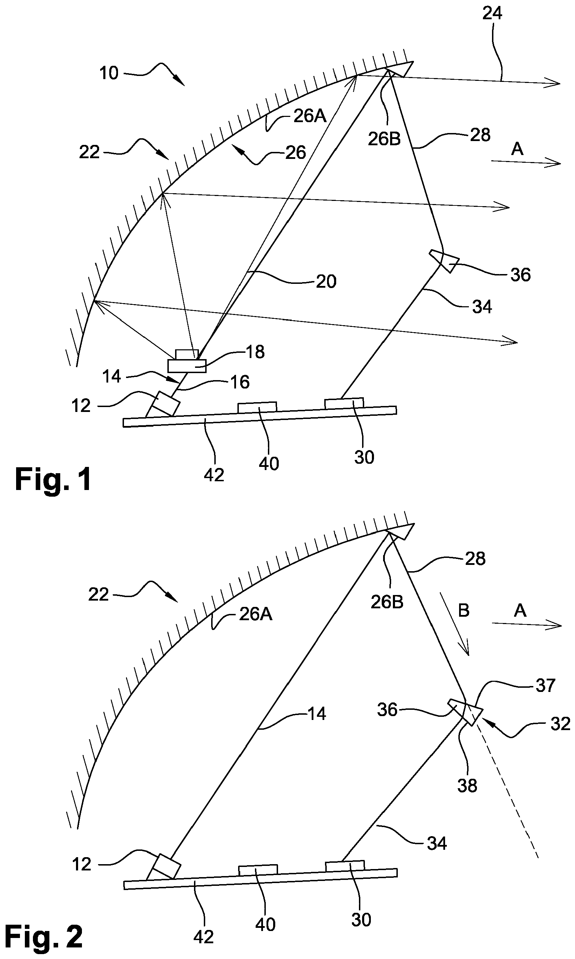

On a représenté à la figure 1 un module 10 lumineux comportant un élément 12 laser à semi-conducteur. L'élément 12 laser est configuré pour émettre un faisceau 14 laser dont l'enveloppe est délimitée par un premier cône 16 de lumière, dit cône 16 d'émission, d'angle d'ouverture très faible resserré autour d'une direction globale d'émission. A cet égard, dans les dessins, le faisceau laser 14 sera représenté par un simple trait. Il s'agit par exemple d'un faisceau 14 laser de couleur bleu.

Lorsque le module 10 lumineux fonctionne normalement, comme cela est illustré à la figure 1, le faisceau 14 laser est intercepté par un élément 18 photoluminescent qui est agencé sur le trajet du faisceau 14 laser. L'élément 18 photoluminescent est configuré pour convertir la longueur d'onde d'au moins une partie dudit faisceau 14 laser en une lumière incohérente d'une longueur d'onde différente de celle du faisceau 14 laser.

En outre, l'élément 18 photoluminescent est conçu pour disperser la lumière le traversant.

Il s'agit par exemple d'un élément optique comportant un luminophore.

Sous l'effet du faisceau 14 laser, l'élément 18 photoluminescent émet de la lumière distribuée dans un faisceau 20 lumineux secondaire d'angle d'ouverture très large comparativement à celui du faisceau 14 laser. La lumière émise dans le faisceau 20 lumineux secondaire est de préférence incohérente, polychromatique ou blanche. Son intensité lumineuse est réduite par rapport à celle du faisceau 14 laser. Cette lumière ne présente ainsi plus de danger pour les usagers de la route.

Le module 10 lumineux comporte aussi un moyen 22 optique pour transformer la lumière provenant de l'élément 18 photoluminescent en un faisceau 24 lumineux sortant orienté dans une direction "A" d'émission. Ce faisceau 24 lumineux sortant est orienté vers l'extérieur du véhicule, par exemple vers l'avant, pour réaliser une fonction d'éclairage ou de signalisation.

Dans l'exemple représenté à la figure 1, le moyen 22 optique présente une surface 26 de réflexion dont une portion 26A principale est sensiblement parabolique. La portion 26A principale de la surface 26 de réflexion est conçue pour transformer, par réflexion, le faisceau 20 secondaire en un faisceau 24 sortant collimaté dans la direction "A" d'émission. A cet effet, l'élément 18 photoluminescent est agencé sensiblement à un foyer de la portion 26A principale de la surface 26 de réflexion.

Lorsque l'élément 18 photoluminescent n'est plus apte à remplir sa fonction, le faisceau 14 laser, passant à proximité du foyer de la portion 26A principale de la surface 26 de réflexion, risque d'être renvoyé par cette dernière dans la direction "A" d'émission.

Pour éviter une telle situation, le moyen 22 optique comporte une portion de guidage qui est agencée pour guider au moins une partie de la lumière émise dans ledit cône 16 d'émission pour former un faisceau lumineux prélevé qui est délimité par un deuxième cône 28 de lumière orienté vers une direction "B" déterminée de prélèvement, dit par la suite "cône 28 de prélèvement".

La portion de guidage est portée de manière fixe par le moyen optique.

Selon le premier mode de réalisation représenté à la figure 2, la portion de guidage est formée par une portion 26B secondaire de la surface 26 de réflexion qui réfléchit la lumière issue du cône 16 d'émission dans le cône 28 de prélèvement. La portion 26B secondaire présentant un état de surface sensiblement lisse, l'angle d'ouverture du cône 28 de prélèvement demeure sensiblement inchangé par rapport à celui du cône 16 d'émission. Pour cette raison, le faisceau 14 laser réfléchi vers la direction "B" de prélèvement est aussi représenté par un trait à la figure 2.

Ladite deuxième direction "B" déterminée de prélèvement est différente de la première direction "A" d'émission du faisceau 24 lumineux sortant. A cet effet, la portion 26B secondaire de guidage est formée par une face sensiblement plane formant une aspérité dans la portion 26A principale de la surface 26 de réflexion.

Avantageusement, la portion 26B de guidage est agencée à une extrémité aval de la surface 26 de réflexion selon le sens de projection du faisceau 24 lumineux sortant, de sorte à ne pas empiéter sur la surface efficace de la surface 26 de réflexion.

En outre, le module 10 lumineux est aussi équipé d'au moins un dispositif 30 de détection d'une lumière incidente dépassant un seuil prédéterminé d'intensité lumineuse, dit "seuil de sécurité" par la suite. A cet effet, le dispositif 30 de détection présente une surface sensible à la lumière. Le dispositif 30 de détection est conçu pour détecter une variation de l'intensité de la radiation lumineuse au-delà dudit seuil de sécurité. Ce seuil de sécurité est déterminé pour garantir que le rayonnement lumineux est sans danger pour la sécurité des usagers de la route.

En variante, le dispositif de détection est conçu pour mesurer de manière absolue l'intensité lumineuse du rayonnement lumineux détecté.

Le dispositif 30 de détection est agencé de manière à détecter la lumière qui est déviée dans le cône 28 de prélèvement. Néanmoins, pour donner une liberté d'agencement du dispositif 30 de détection, par exemple pour permettre d'obtenir un module 10 lumineux plus compact et plus simple à ajuster, il est avantageux de pouvoir dévier précisément la lumière prélevée vers le dispositif 30 de détection.

A cet effet, le dispositif 30 de détection est agencé en dehors du cône 28 de prélèvement. Le module 10 lumineux comporte un moyen 32 de déviation agencé en travers du cône 28 de prélèvement pour dévier la lumière incidente en un faisceau de mesure délimité par un troisième cône 34 de lumière, dit cône 34 de mesure, dirigé vers la surface sensible du dispositif 30 de détection.

Le moyen 32 de déviation comporte au moins un élément 36 optique qui est traversé par la lumière et qui comporte une face 37 d'entrée de rayon lumineux compris dans le cône 28 de prélèvement et une face 38 de sortie de la lumière distribuée dans le cône 34 de mesure.

Le moyen 32 de déviation est formé d'au moins un élément séparé du moyen 22 optique.

Dans ce premier mode de réalisation, le moyen 32 de déviation comporte un unique élément 36 optique.

En variante non représentée de ce mode de réalisation, le moyen de déviation comporte plusieurs éléments optiques.

L'élément 36 optique dévie la lumière par réfraction. L'élément 36 optique est ici formé par un prisme.

En variante non représentée de l'invention, l'élément optique est formé par une lentille.

Etant donné qu'après réfraction, l'angle d'ouverture du cône 34 de mesure demeure sensiblement inchangé par rapport à celui du cône 28 de prélèvement, le troisième cône 34 de lumière a été représenté par un trait plein à la figure 2. On a représenté en traits interrompus le cône 28 de prélèvement dans lequel les rayons lumineux poursuivraient leur trajet en l'absence du moyen 32 de déviation. On constate que la surface sensible du dispositif 30 de détection est agencée en dehors du cône 28 de prélèvement.

Le module 10 lumineux comporte en outre un moyen 40 de pilotage, par exemple une unité électronique de commande, qui est apte à commander la désactivation de l'élément 12 laser, par exemple en coupant l'alimentation électrique de l'élément 12 laser.

La surveillance de l'intensité lumineuse des rayons lumineux compris dans le cône 34 de mesure permet de contrôler que l'élément 18 photoluminescent rempli correctement son rôle.

Lorsque le module 10 lumineux fonctionne normalement, comme illustré à la figure 1, la lumière issue du faisceau 14 laser a été convertie et dispersée par l'élément 18 photoluminescent avant d'être émise vers la surface 26 de réflexion pour former le faisceau 24 lumineux sortant. La portion 26B de guidage prélève une partie des rayons lumineux, qui présentent ainsi les mêmes propriétés que les rayons lumineux formant le faisceau 24 lumineux sortant. Ces rayons lumineux prélevés sont ensuite déviés par le moyen 32 de déviation dans le cône 34 de mesure dans une direction de propagation orientée vers la surface sensible du dispositif 30 de détection. Ainsi, la lumière incidente sur le dispositif 30 de détection présente une intensité lumineuse modérée qui est inférieure au seuil de sécurité, garantissant un usage sécurisé du module 10 lumineux.

En revanche, le moyen 40 de pilotage est conçu pour désactiver l'élément 12 laser lorsque l'intensité lumineuse des rayons lumineux contenus dans le cône 34 de mesure excède le seuil de sécurité.

La figure 2 représente le module 10 lumineux lorsque l'élément 18 photoluminescent ne remplit plus sa fonction. L'élément 18 photoluminescent a par exemple été délogé de son emplacement suite à un choc, il n'est ainsi plus agencé sur le trajet du faisceau 14 laser. En l'absence de l'élément 18 photoluminescent, le faisceau 14 laser dont l'intensité lumineuse est potentiellement dangereuse vient frapper directement la portion 26B de guidage qui est agencée dans le cône 16 d'émission.

Au moins une partie du faisceau 14 laser est réfléchie dans le cône 28 de prélèvement. Puis la lumière guidée dans le cône 28 de prélèvement est déviée par l'élément 36 optique dans le cône 34 de mesure dans une direction de propagation orientée directement vers la surface sensible du dispositif 30 de détection. Les rayons lumineux atteignant la surface sensible du dispositif 30 de détection présentent alors une intensité lumineuse qui n'a sensiblement pas été atténuée par rapport à la sortie du faisceau 14 laser. Ainsi, l'intensité lumineuse des rayons lumineux déviés par l'élément 36 optique vers le dispositif 30 de détection dépasse le seuil de sécurité.

Le dépassement du seuil de sécurité est communiqué par le dispositif 30 de détection au moyen 40 de pilotage. En réaction, le moyen 40 de pilotage désactive l'élément 12 laser. De cette manière, le moyen 40 de pilotage interrompt la production du faisceau 14 laser, empêchant tout rayonnement lumineux nocif de sortir du module 10 lumineux.

Comme représenté aux figures 1 et 2, l'élément 12 laser et la photodiode formant ici le dispositif 30 de détection sont portées par un support 42 commun. Le support 42 commun assure simultanément la fixation mécanique et la connexion électrique de l'élément 12 laser et du dispositif 30 de détection. Le support 42 commun est ici formé par une carte électronique commune.

Le moyen 32 de déviation permet avantageusement de décaler le dispositif 30 de détection en direction de l'élément 12 laser sur le support 42 commun par rapport au cône 28 de prélèvement. Ceci permet de réaliser un support 42 plus compact.

En outre, la position de l'élément 36 optique formant le moyen 32 de déviation est susceptible d'être ajustée indépendamment de la position de la portion 26B de guidage. Ceci permet d'ajuster précisément la direction de propagation du cône 34 de mesure vers la surface sensible du dispositif 30 de détection, indépendamment des tolérances de positionnement des moyens de guidage de la lumière.

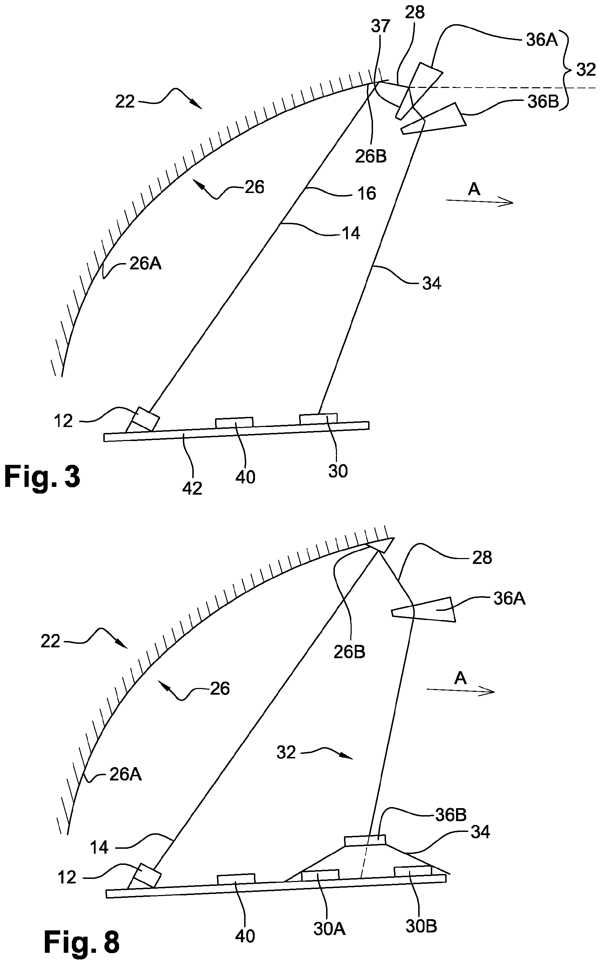

Un deuxième mode de réalisation de l'invention a été représenté à la figure 3. Ce deuxième mode de réalisation présente de nombreuses similarités avec le premier mode de réalisation. Seules les différences seront détaillées par la suite.

Dans le module 10 lumineux réalisé selon ce deuxième mode de réalisation, la portion 26B de guidage renvoi les rayons lumineux issus du cône 16 d'émission dans la même direction générale que le faisceau 24 lumineux sortant. A cet égard, la portion 26B de guidage est formée par une portion de la surface 26 de réflexion qui complète la portion 26B principale de la surface 26 de réflexion. Ainsi le cône 28 de prélèvement est orienté globalement dans la direction "A" d'émission du faisceau 24 lumineux sortant.

Pour permettre de dévier les rayons lumineux du cône 28 de prélèvement en direction du dispositif 30 de détection, le moyen 32 de déviation comporte ici un premier élément 36A optique amont et un deuxième élément 36B optique aval. Les éléments optiques dévient tous les deux la lumière par réfraction, il s'agit par exemple de prismes.

L'élément 36A optique amont est agencé en travers du cône 28 de prélèvement pour dévier ainsi une première fois les rayons lumineux entrant par sa face 37 d'entrée vers l'élément 36B optique aval. Puis l'élément 36B optique aval dévie lesdits rayons lumineux déviés par l'élément 36A optique amont dans le cône 34 de mesure dans une direction de propagation orientée directement vers le dispositif 30 de détection.

La série d'éléments 36A, 36B optiques formant le moyen 32 de déviation permet ainsi de dévier les rayons lumineux issus du cône 28 de prélèvement d'un angle très important. La géométrie de la surface 26 de réflexion est ainsi simplifiée par rapport à celle du premier mode de réalisation tout en conservant un support 42 commun très compact pour l'élément 12 laser et le dispositif 30 de détection.

De plus, au moins l'un des éléments 36A, 36B optiques est un élément séparé du moyen 22 optique pour permettre l'ajustement de la direction de propagation du cône 34 de mesure indépendamment des tolérances de positionnement de la portion 26B de guidage.

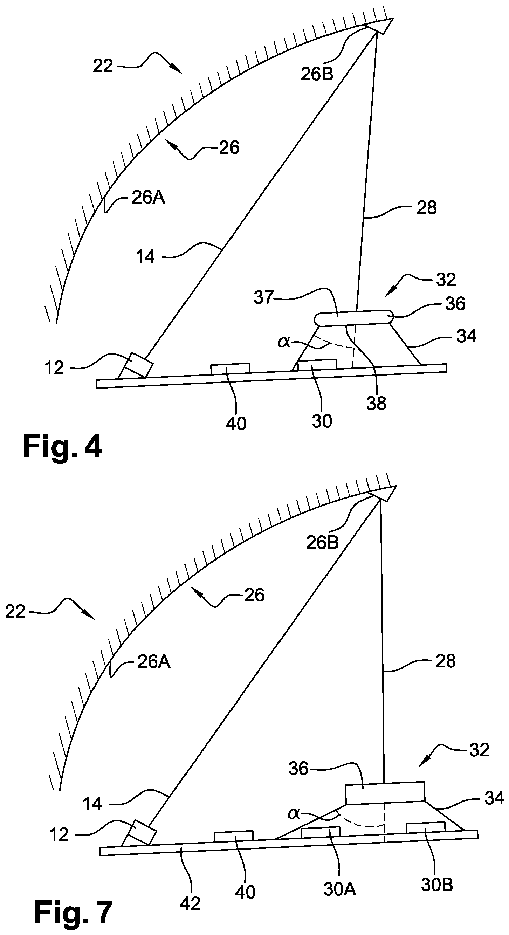

Un troisième mode de réalisation de l'invention est représenté à la figure 4. Ce mode de réalisation est similaire à celui qui a été décrit au premier mode de réalisation. Seules les différences seront décrites par la suite.

Dans ce troisième mode de réalisation, le moyen 32 de déviation comporte des moyens d'étalement de la lumière pour que le cône 34 de mesure présente un angle d'ouverture supérieur à celui du deuxième cône 28 de prélèvement. Ainsi le faisceau lumineux de mesure est très divergent par rapport au faisceau prélevé.

Dans l'exemple réalisation représenté à la figure 4, le cône 34 de mesure est dirigé sensiblement dans la même direction que le cône 28 de prélèvement. Néanmoins, une partie des rayons lumineux issus du cône 28 de prélèvement sont déviés vers l'extérieur du cône 28 de prélèvement du fait de l'angle d'ouverture supérieure du cône 34 de mesure.

Le moyen 32 de déviation comporte ici un unique élément 36 optique conçu pour être traversé par la lumière. Au moins l'une des faces parmi la face 37 d'entrée et la face 38 de sortie de l'élément 36 optique est structurée pour étaler la lumière sortante dans le cône 34 de mesure.

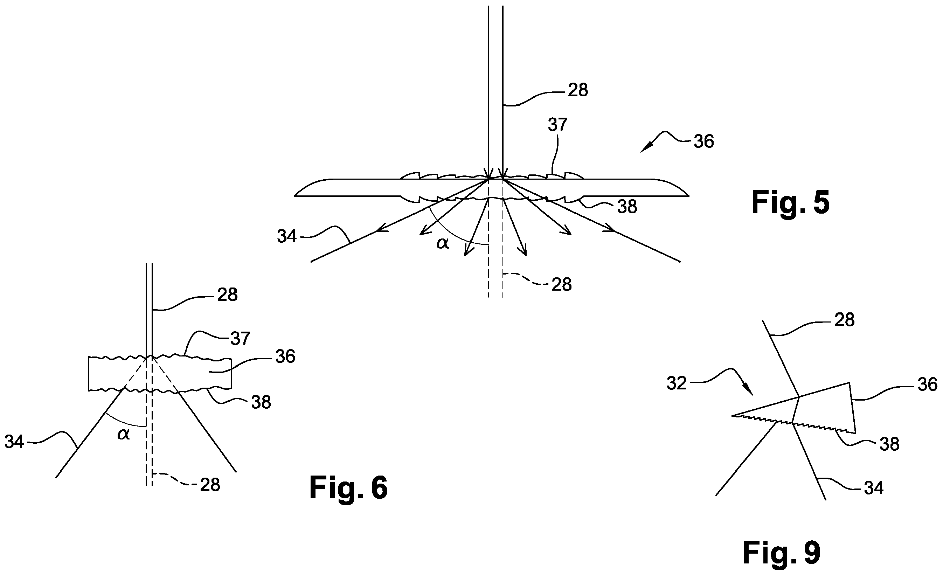

L'élément 36 optique a été représenté plus en détails à la figure 5. La face 37 d'entrée et la face 38 de sortie de l'élément 36 optique sont toutes les deux structurées pour étaler la lumière sortante dans le cône 34 de mesure par réfraction. Chaque face 37, 38 comporte ainsi des stries permettant d'étaler la lumière au moins dans un plan avec un angle d'ouverture α qui est sensiblement supérieur à l'angle d'ouverture presque nul du cône 28 de prélèvement. Ainsi, à distance égale en aval de l'élément 36 optique, la surface éclairée par le cône 34 de mesure est très supérieure à la surface éclairée par le cône 28 de prélèvement à hauteur du support 42 du dispositif 30 de détection.

Comme représenté à la figure 4, le dispositif 30 de détection est décalé à l'extérieur du cône 28 de prélèvement, en périphérie et à l'intérieur du cône 34 de mesure. Ainsi, le dispositif 30 de détection est exposé uniquement aux rayons lumineux déviés par le moyen 32 de déviation et non aux rayons lumineux poursuivant leur trajet dans le cône 28 de prélèvement.

Un tel mode de réalisation permet avantageusement d'homogénéiser la lumière incidente sur le dispositif 30 de détection.

En outre, le cône 34 de mesure présente un angle d'ouverture suffisant pour éclairer la totalité de la surface sensible du dispositif 30 de détection. Ceci permet de simplifier énormément le réglage de la saturation du dispositif 30 de détection.

Selon une variante de ce troisième mode de réalisation qui est représentée à la figure 6, l'élément 36 optique du moyen 32 de déviation dévie la lumière par diffusion. Dans l'exemple représenté à la figure 6, au moins l'une des faces parmi la face 37 d'entrée et la face 38 de sortie de l'élément optique présente un état de surface favorisant la diffusion la lumière. La face 37 d'entrée et/ la face 38 de sortie est par exemple grenée.

En variante, le matériau constituant l'élément 36 optique favorise la diffusion de la lumière.

Un quatrième mode de réalisation de l'invention a été représenté à la figure 7. Ce quatrième mode de réalisation de l'invention est identique en tout point au troisième mode de réalisation excepté le fait que le module 10 lumineux comporte ici plusieurs dispositifs de détection de l'intensité lumineuse. Au moins l'un des dispositifs de détection est agencé en dehors du cône 28 de prélèvement.

Dans l'exemple représenté à la figure 7, il comporte deux dispositifs 30A, 30B de détection. Chaque dispositif 30A, 30B de détection est apte à communiquer avec le moyen 40 de pilotage pour permettre de désactiver l'élément 12 laser lorsqu'un dépassement du seuil de sécurité est détecté par l'un et/ou l'autre des dispositifs 30A, 30B de détection.

Chacun de ces dispositifs 30A, 30B de détection est agencé dans le cône 34 de mesure. Les deux dispositifs 30A, 30B sont ici agencés en dehors du cône 28 de prélèvement.

En variante, seul l'un des dispositifs de détection est agencé en dehors du cône de prélèvement.

Les deux dispositifs 30A, 30B sont portés par le support 42 commun. Ceci permet d'obtenir un module 10 lumineux plus compact.

La présence des deux dispositifs 30A, 30B de détection permet de détecter de manière redondante l'intensité des rayons lumineux du cône 34 de mesure. Il est ainsi possible de diagnostiquer le défaut de fonctionnement de l'un des dispositifs 30A, 30B de détection lorsque les dispositifs 30A, 30B de détection communiquent des informations contradictoires au moyen 40 de pilotage.

Comme expliqué précédemment, les deux premiers modes de réalisation permettent de dévier la direction globale de propagation du cône 34 de mesure, par exemple par réfraction, par rapport à celle du cône 28 de prélèvement, tandis que les troisième et quatrième modes de réalisation permettent de dévier les rayons lumineux pour obtenir un cône 34 de mesure présentant un angle d'ouverture supérieur à celui du cône 28 de prélèvement sans en modifier la direction globale de propagation.

Bien entendu, comme cela est représenté à la figure 8, il est possible de combiner les différents modes de réalisation décrits précédemment pour obtenir un cône 34 de mesure qui présente simultanément un angle d'ouverture plus grand et une direction globale de propagation différente par rapport à celle du cône 28 de prélèvement.

Dans l'exemple représenté à la figure 8, le moyen 32 de déviation comporte un élément 36A optique amont et un élément 36B optique aval.

L'élément 36A optique amont a ici pour fonction de dévier la direction globale de propagation du cône 28 de prélèvement par réfraction. Il s'agit ici d'un prisme. Un faisceau intermédiaire émerge ainsi de cet élément 36A optique amont en direction l'élément 36B optique aval. Ce faisceau intermédiaire est compris dans un cône 44 intermédiaire présentant une direction globale de propagation différente de celle du deuxième cône 28 de lumière, mais leurs angles d'ouverture sont sensiblement équivalents.

L'élément 36B optique aval a ici pour fonction de dévier une partie des rayons lumineux du cône 44 intermédiaire pour étaler la lumière dans le cône 34 de mesure. Le cône 34 de mesure présente ainsi une direction globale de propagation identique à celle du cône 44 intermédiaire mais un angle d'ouverture supérieur.

Selon une variante de réalisation représentée à la figure 9, les fonctions de déviation de la direction globale de propagation et d'élargissement de l'angle d'ouverture du cône 34 de mesure sont remplies par un unique élément 36 optique. Il s'agit ici d'un prisme dont la face de sortie est grenée ou structurée pour étaler la lumière.

On pourra bien entendu envisager des variantes de réalisation de chacun des modes de réalisation précédemment décrits.

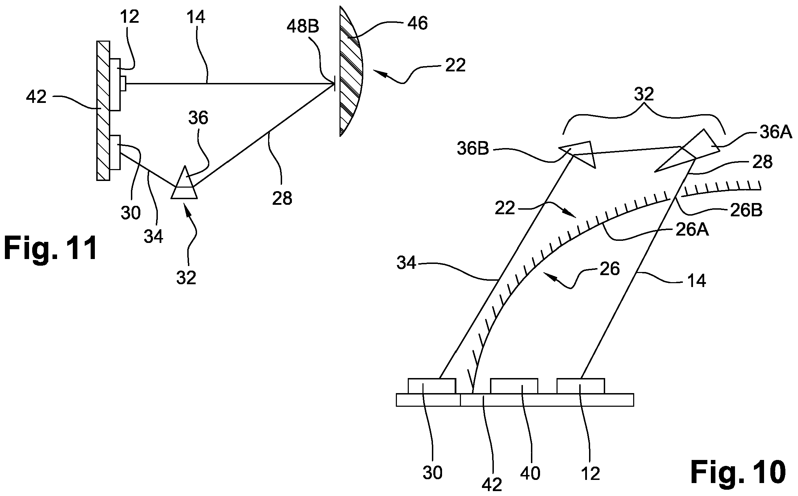

Par exemple, en référence à la figure 10, la portion 26B de guidage est formé par un orifice qui traverse une portion secondaire de surface 26 de réflexion. Le faisceau lumineux prélevé par cet orifice 26B est ainsi compris dans un cône 28 de prélèvement qui est dirigé vers le moyen 32 de déviation, ici similaire à celui qui est décrit dans le deuxième mode de réalisation, pour être acheminé jusqu'au dispositif 30 de détection.

Cette variante de réalisation permet ainsi avantageusement d'agencer le dispositif 30 de détection sur le même support 42 que l'élément 14 laser.

Bien entendu une telle variante est applicable à l'un quelconque des modes de réalisation précédemment décrits.

Selon une autre variante de réalisation représentée à la figure 11, le moyen 22 optique transformant la lumière provenant de l'élément 18 photoluminescent en faisceau 24 lumineux sortant comporte une lentille 46. La lentille 46 comporte une face 48 incidente qui reçoit la lumière issue de l'élément 18 photoluminescent.

Ladite face 48 incidente comporte une portion 48B de guidage qui est par exemple formée par une portion métallisée qui est apte à réfléchir les rayons lumineux incident du faisceau 14 laser pour former un cône 28 de prélèvement. Comme dans le premier mode de réalisation, un moyen 32 de déviation, ici un prisme 36, dévie les rayons lumineux du cône 28 de prélèvement dans un cône 34 de mesure en direction du dispositif 30 de détection.

Bien entendu, cette variante peut être combinée avec l'un quelconque des modes de réalisation précédemment décrits.

Le module 10 lumineux réalisé selon les enseignements de l'invention permet ainsi de donner une liberté dans la tolérance de positionnement du dispositif 30 de détection par rapport à la portion de guidage. En effet, le moyen de déviation comporte un élément optique séparé qui est susceptible d'être réglé en position par rapport à la portion de guidage et par rapport au dispositif 30 de détection pour ajuster précisément la direction de propagation du cône 34 de mesure.

De plus, la possibilité d'obtenir un faisceau de mesure présentant un angle d'ouverture plus large permet d'éclairer la totalité de la surface sensible du dispositif 30 de détection, facilitant ainsi le réglage de sa saturation.

En outre, lorsque l'angle d'ouverture est conçu pour être suffisamment large, il est possible d'agencer deux dispositifs 30 de détection dans un même faisceau de mesure. Ainsi, le module 10 lumineux fonctionne de manière beaucoup plus sécurisée.

## Revendications

1. Module (10) lumineux, notamment pour un véhicule automobile, destiné à émettre un faisceau (24) lumineux sortant et comportant :
- au moins un élément (12) laser à semi-conducteur configuré pour émettre un faisceau (14) laser dans un premier cône (16) de lumière ;
- un élément (18) photoluminescent configuré pour convertir au moins une partie dudit faisceau (14) laser ;
- un moyen (22) optique pour transformer la lumière provenant de l'élément (18) photoluminescent en ledit faisceau (24) lumineux sortant orienté dans une direction (A) d'émission, le moyens (22) optique comportant une portion (26B) de guidage agencée pour guider au moins une partie de la lumière émise dans ledit premier cône (16) de lumière dans un deuxième cône (28) de lumière ;
- au moins un dispositif (30) de détection d'une lumière incidente dépassant un seuil prédéterminé d'intensité lumineuse ;
**caractérisé en ce que** le dispositif (30) de détection est agencé en dehors du deuxième cône (28) de lumière et **en ce que** le module (10) lumineux comporte un moyen (32) de déviation agencé en travers du deuxième cône (28) de lumière pour dévier la lumière incidente dans un troisième cône (34) de lumière dirigé vers le dispositif (30) de détection.

2. Module (10) lumineux selon la revendication précédente, **caractérisé en ce que** le moyen (32) de déviation comporte au moins un élément (36, 36A, 36B) optique qui est traversé par la lumière et qui comporte une face (37) d'entrée de la lumière du deuxième cône (28) de lumière et une face (38) de sortie de la lumière selon le troisième cône (34) de lumière.

3. Module (10) lumineux selon la revendication précédente, **caractérisé en ce que** l'élément (36, 36A) optique dévie la lumière par réfraction.

4. Module (10) lumineux selon l'une quelconque des revendications précédentes, **caractérisé en ce que** le moyen (32) de déviation comporte des moyens d'étalement de la lumière pour que le troisième cône (34) de lumière présente un angle d'ouverture supérieur à celui du deuxième cône (28) de lumière.

5. Module (10) lumineux selon la revendication 4, **caractérisé en ce qu'**au moins l'une des faces parmi la face (37) d'entrée et la face (38) de sortie de l'élément (36) optique présente un état de surface diffusant la lumière.

6. Module (10) lumineux selon l'une quelconque des revendications 4 ou 5, **caractérisé en ce qu'**il comporte au moins deux dispositifs (30A, 30B) de détection qui sont chacun agencés dans le troisième cône (34) de lumière.

7. Module (10) lumineux selon la revendication précédente, **caractérisé en ce que** chaque dispositif (30A, 30B) de détection est agencé en dehors du deuxième cône (28) de lumière.

8. Module (10) lumineux selon l'une quelconque des revendications précédentes, **caractérisé en ce que** le moyen (22) optique comporte une surface (26) de réflexion dont une portion (26A) principale réfléchit de la lumière provenant de l'élément (18) photoluminescent pour former ledit faisceau (24) lumineux sortant.

9. Module (10) lumineux selon la revendication précédente, **caractérisé en ce que** la portion de guidage est formée par une portion (26B) secondaire de la surface (26) de réflexion qui réfléchit la lumière issue du premier cône (16) de lumière dans le deuxième cône (28) de lumière.

10. Module (10) lumineux selon la revendication 8, **caractérisé en ce que** la portion de guidage est formée par un orifice (26B) qui traverse une portion secondaire de la surface (26) de réflexion.

11. Module (10) lumineux selon l'une quelconque des revendications précédentes, **caractérisé en ce que** le dispositif (30) de détection et l'élément (12) laser sont portés par un support (42) commun, notamment par une carte électronique commune.

12. Module (10) lumineux selon l'une quelconque des revendications précédentes, **caractérisé en ce qu'**il comporte un moyen (40) de pilotage de l'élément (12) laser qui est destiné à interrompre l'émission du faisceau (14) laser lorsque le dispositif (30) de détection détecte une intensité supérieure au seuil prédéterminé.

13. Module (10) lumineux selon l'une quelconque des revendications précédentes, **caractérisé en ce que** la portion (26B) de guidage du moyen (22) optique guide au moins une partie de la lumière émise dans ledit premier cône (16) de lumière dans un deuxième cône (28) de lumière orienté vers une deuxième direction (B) déterminée qui est différente de la première direction d'émission (A) du faisceau (24) lumineux sortant.

14. Module (10) lumineux selon l'une quelconque des revendications précédentes, **caractérisé en ce que** le moyen (32) de déviation est formé d'au moins un élément (36, 36A, 36B) optique séparé de l'élément portant la portion de guidage.

15. Module (10) lumineux selon l'une quelconque des revendications précédentes, **caractérisé en ce que** la portion (26B) de guidage est porté de manière fixe par le moyen (22) optique.

## Patentansprüche

1. Lichtmodul (10), insbesondere für ein Kraftfahrzeug, das dazu bestimmt ist, einen Austrittslichtstrahl (24) auszusenden, und das umfasst:
- mindestens ein Halbleiter-Laserelement (12), das dazu bestimmt ist, einen Laserstrahl (14) in einem ersten Lichtkegel (16) auszusenden;
- ein photolumineszierendes Element (18), das dazu bestimmt ist, mindestens einen Teil des Laserstrahls (14) umzuwandeln;
- ein optisches Mittel (22) zum Umwandeln des von dem photolumineszenten Element (18) kommenden Lichts in den Austrittslichtstrahl (24), der in einer Emissionsrichtung (A) ausgerichtet ist, wobei das optische Mittel (22) einen Führungsabschnitt (26B) aufweist, der so angeordnet ist, dass er mindestens einen Teil des in dem ersten Lichtkegel (16) emittierten Lichts in einen zweiten Lichtkegel (28) leitet;
- mindestens eine Vorrichtung (30) zur Detektion von einfallendem Licht, das größer als eine vorbestimmte Schwelle der Lichtstärke ist;
**dadurch gekennzeichnet, dass** die Detektionsvorrichtung (30) außerhalb des zweiten Lichtkegels (28) angeordnet ist und dass das Lichtmodul (10) ein Mittel (32) zur Ablenkung umfasst, das quer über den zweiten Lichtkegel (28) angeordnet ist, um das einfallende Licht in einen dritten Lichtkegel (34) abzulenken, der auf die Detektionsvorrichtung (30) gerichtet ist.

2. Lichtmodul (10) nach dem vorhergehenden Anspruch, **dadurch gekennzeichnet, dass** das Ablenkmittel (32) mindestens ein optisches Element (36, 36A, 36B) umfasst, durch das das Licht hindurchgeht und das eine Eintrittsfläche (37) für das Licht des zweiten Lichtkegels (28) und eine Austrittsfläche (38) für das Licht des dritten Lichtkegels (34) aufweist.

3. Lichtmodul (10) nach dem vorhergehenden Anspruch, **dadurch gekennzeichnet, dass** das optische Element (36, 36A) das Licht durch Brechung ablenkt.

4. Lichtmodul (10) nach einem der vorstehenden Ansprüche, **dadurch gekennzeichnet, dass** die Mittel (32) zur Ablenkung Mittel zur Ausbreitung des Lichts umfassen, so dass der dritte Lichtkegel (34) einen Öffnungswinkel aufweist, der größer ist als der des zweiten Lichtkegels (28).

5. Lichtmodul (10) nach Anspruch 4, **dadurch gekennzeichnet, dass** mindestens eine der Flächen zwischen der Eintrittsfläche (37) und der Austrittsfläche (38) des optischen Elements (36) einen das Licht streuenden Oberflächenzustand aufweist.

6. Lichtmodul (10) nach einem der Ansprüche 4 oder 5, **dadurch gekennzeichnet, dass** es mindestens zwei Detektionsvorrichtungen (30A, 30B) umfasst, die jeweils im dritten Lichtkegel (34) angeordnet sind.

7. Lichtmodul (10) nach dem vorhergehenden Anspruch, **dadurch gekennzeichnet, dass** jede Detektionsvorrichtung (30A, 30B) außerhalb des zweiten Lichtkegels (28) angeordnet ist.

8. Lichtmodul (10) nach einem der vorstehenden Ansprüche, **dadurch gekennzeichnet, dass** das optische Mittel (22) eine Reflexionsfläche (26) umfasst, von der ein Hauptteil (26A) das von dem photolumineszierenden Element (18) kommende Licht reflektiert, um den Ausgangslichtstrahl (24) zu bilden.

9. Lichtmodul (10) nach dem vorhergehenden Anspruch, **dadurch gekennzeichnet, dass** der leitende Teil durch einen sekundären Teil (26B) der Reflexionsfläche (26) gebildet wird, der das von dem ersten Lichtkegel (16) kommende Licht in den zweiten Lichtkegel (28) reflektiert.

10. Lichtmodul (10) nach Anspruch 8, **dadurch gekennzeichnet, dass** der leitende Teil durch eine Öffnung (26B) gebildet wird, die durch einen sekundären Teil der Reflexionsfläche (26) hindurchgeht.

11. Lichtmodul (10) nach einem der vorstehenden Ansprüche, **dadurch gekennzeichnet, dass** die Detektionsvorrichtung (30) und das Laserelement (12) von einem gemeinsamen Träger (42), insbesondere von einer gemeinsamen elektronischen Karte, getragen werden.

12. Lichtmodul (10) nach einem der vorstehenden Ansprüche, **dadurch gekennzeichnet, dass** es ein Mittel (40) zur Steuerung des Laserelements (12) umfasst, das dazu bestimmt ist, die Aussendung des Laserstrahls (14) zu unterbrechen, wenn die Erfassungsvorrichtung (30) eine Intensität erfasst, die größer als der vorgegebene Schwellenwert ist.

13. Lichtmodul (10) nach einem der vorstehenden Ansprüche, **dadurch gekennzeichnet, daß** der leitende Teil (26B) der optischen Mittel (22) mindestens einen Teil des in dem ersten Lichtkegel (16) emittierten Lichts in einen zweiten Lichtkegel (28) leitet, der in einer zweiten bestimmten Richtung (B) ausgerichtet ist, die sich von der ersten Emissionsrichtung (A) des austretenden Lichtstrahls (24) unterscheidet.

14. Lichtmodul (10) nach einem der vorstehenden Ansprüche, **dadurch gekennzeichnet, daß** das Ablenkmittel (32) durch mindestens ein optisches Element (36, 36A, 36B) gebildet wird, das von dem den Führungsteil tragenden Element getrennt ist.

15. Lichtmodul (10) nach einem der vorstehenden Ansprüche, **dadurch gekennzeichnet, dass** der Führungsteil (26B) fest von den optischen Mitteln (22) getragen wird.

## Claims

1. Light module (10), especially for a motor vehicle, designed to emit an exit light beam (24) and comprising:
- at least one semiconductor laser element (12) designed to emit a laser beam (14) in a first cone of light (16);
- a photoluminescent element (18) designed to convert at least a portion of said laser beam (14);
- an optical means (22) for transforming the light coming from the photoluminescent element (18) into said exit light beam (24) oriented in a direction of emission (A), the optical means (22) comprising a guiding portion (26B) arranged to guide at least a portion of the light emitted in said first cone of light (16) into a second cone of light (28);
- at least one device (30) for detection of incident light greater than a predetermined threshold of luminous intensity;
**characterized in that** the detection device (30) is arranged outside of the second cone of light (28) and **in that** the light module (10) comprises a means (32) of deviation arranged across the second cone of light (28) in order to deviate the incident light into a third cone of light (34) directed toward the detection device (30).

2. Light module (10) according to the preceding claim, **characterized in that** the means (32) of deviation comprises at least one optical element (36, 36A, 36B) through which the light passes and which comprises an entrance face (37) for the light of the second cone of light (28) and an exit face (38) for the light in the third cone of light (34).

3. Light module (10) according to the preceding claim, **characterized in that** the optical element (36, 36A) deviates the light by refraction.

4. Light module (10) according to any one of the preceding claims, **characterized in that** the means (32) of deviation comprises means of spreading the light so that the third cone of light (34) has an aperture angle greater than that of the second cone of light (28).

5. Light module (10) according to Claim 4, **characterized in that** at least one of the faces among the entrance face (37) and the exit face (38) of the optical element (36) has a surface state diffusing the light.

6. Light module (10) according to any one of Claims 4 or 5, **characterized in that** it comprises at least two detection devices (30A, 30B), each of them arranged in the third cone of light (34).

7. Light module (10) according to the preceding claim, **characterized in that** each detection device (30A, 30B) is arranged outside of the second cone of light (28).

8. Light module (10) according to any one of the preceding claims, **characterized in that** the optical means (22) comprises a reflection surface (26) of which a principal portion (26A) reflects light coming from the photoluminescent element (18) to form said exit light beam (24).

9. Light module (10) according to the preceding claim, **characterized in that** the guiding portion is formed by a secondary portion (26B) of the reflection surface (26) which reflects the light coming from the first cone of light (16) into the second cone of light (28).

10. Light module (10) according to Claim 8, **characterized in that** the guiding portion is formed by an orifice (26B) which passes through a secondary portion of the reflection surface (26).

11. Light module (10) according to any one of the preceding claims, **characterized in that** the detection device (30) and the laser element (12) are carried by a common support (42), especially by a common electronic card.

12. Light module (10) according to any one of the preceding claims, **characterized in that** it comprises a means (40) of control of the laser element (12) which is designed to interrupt the emission of the laser beam (14) when the detection device (30) detects an intensity greater than the predetermined threshold.

13. Light module (10) according to any one of the preceding claims, **characterized in that** the guiding portion (26B) of the optical means (22) guides at least a portion of the light emitted in said first cone of light (16) into a second cone of light (28) oriented in a second determined direction (B) which is different from the first direction of emission (A) of the exit light beam (24).

14. Light module (10) according to any one of the preceding claims, **characterized in that** the means (32) of deviation is formed by at least one optical element (36, 36A, 36B) separate from the element carrying the guiding portion.

15. Light module (10) according to any one of the preceding claims, **characterized in that** the guiding portion (26B) is carried in fixed manner by the optical means (22).
